# FASCICULE DE BREVET EUROPEEN

(11) **EP 3 069 438 B1**
(45) Date de publication et mention de la délivrance du brevet: **31.01.2018**
(21) Numéro de dépôt: 14825376.8
(22) Date de dépôt: 23.10.2014
(51) Int. Cl.: H02N 2/18, C08L 1/28, C08L 27/16, H01L 37/02, H01L 41/113

(54) **SYSTEME DE CONVERSION D'ENERGIE THERMIQUE ET/OU MECANIQUE EN ENERGIE ELECTRIQUE**
SYSTEM ZUM UMWANDELN VON MECHANISCHER UND/ODER WÄRMEENERGIE IN ELEKTRISCHE ENERGIE
SYSTEM FOR CONVERTING MECHANICAL AND/OR THERMAL ENERGY INTO ELECTRICAL POWER

(30) Priorité: 15.11.2013 FR 1361163
(43) Date de publication de la demande: 21.09.2016
(73) Titulaire: Commissariat à l'Énergie Atomique et aux Énergies Alternatives, 75015 Paris (FR)
(72) Inventeur: ALIANE, Abdelkader, F-38100 Grenoble (FR); PONCELET, Olivier, F-38000 Grenoble (FR)
(74) Mandataire: Thibon, Laurent
(86) Numéro de dépôt international: PCT/FR2014/052709
(87) Numéro de publication internationale: WO 2015/071566

(56) Documents cités:
- EP-A1- 2 309 560
- EP-A1- 2 312 154
- KUMAR ET AL: "Smart polymers: Physical forms and bioengineering applications", PROGRESS IN POLYMER SCIENCE, PERGAMON PRESS, OXFORD, GB, vol. 32, no. 10, 28 septembre 2007 (2007-09-28), pages 1205-1237, XP022277244, ISSN: 0079-6700, DOI: 10.1016/J.PROGPOLYMSCI.2007.05.003
- DI PASQUALE G ET AL: "All polymeric transducers for energy harvesting", SENSORS, 2010 IEEE, IEEE, PISCATAWAY, NJ, USA, 1 novembre 2010 (2010-11-01), pages 837-840, XP031978300, DOI: 10.1109/ICSENS.2010.5691012 ISBN: 978-1-4244-8170-5
- GUENTHER ET AL: "Chemical sensors based on multiresponsive block copolymer hydrogels", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER S.A, CH, vol. 126, no. 1, 20 septembre 2007 (2007-09-20), pages 97-106, XP022261792, ISSN: 0925-4005, DOI: 10.1016/J.SNB.2006.10.054

## Description

### Domaine

La présente demande concerne un système permettant de convertir de l'énergie thermique et/ou mécanique en énergie électrique et un procédé de fabrication d'un tel système.

### Exposé de l'art antérieur

Les systèmes de conversion d'énergie thermique / mécanique en énergie électrique peuvent notamment être utilisés pour la réalisation de capteurs de pression, d'interrupteurs ou de systèmes de récupération d'énergie.

Il est connu de réaliser des systèmes de conversion d'énergie en utilisant des films piézoélectriques et/ou pyroélectriques. Toutefois, l'action piézoélectrique et/ou pyroélectrique des films actuellement connus peut être insuffisante pour réaliser un système de conversion d'énergie thermique et/ou mécanique en énergie électrique qui soit suffisamment sensible.

En outre, lorsque le système de conversion d'énergie est utilisé pour réaliser un interrupteur, notamment un interrupteur actionné manuellement par un utilisateur, il peut être souhaitable, lorsque l'utilisateur actionne l'interrupteur, que l'interrupteur exerce en retour une force mécanique sur l'utilisateur, par exemple l'application d'une surpression, notamment pour que l'utilisateur soit sûr d'avoir actionné convenablement l'interrupteur. Il est alors nécessaire de prévoir des moyens supplémentaires pour fournir cette réaction mécanique.

La demande de brevet EP 2 309 560 décrit un système de conversion d'énergie. La publication de Kumar et al intitulée "Smart polymers: Physical forms and bioengineering applications" (Progress in Polymer Science, Pergamon Press, Oxford, GB, vol. 32, N° 10, pages 1205-1237, 2007-09-28) décrit des applications pour les polymères intelligents. La publication de Guenther et al intitulée "Chemical sensors based on multiresponsive block copolymer hydrogels" (Sensors and Actuators B: Chemical vol. 126, n° 1, pages 97-106, 2007-09-20) décrit un capteur chimique comprenant des hydrogels de copolymères.

### Résumé

Un mode de réalisation vise à pallier tout ou partie des inconvénients des systèmes connus de conversion d'énergie thermique/mécanique en énergie électrique.

Un autre mode de réalisation vise à permettre l'utilisation d'un film pyroélectrique et/ou piézoélectrique pour la réalisation du système de conversion d'énergie.

Un autre mode de réalisation vise, dans le cas d'une utilisation du système de conversion d'énergie pour la réalisation d'un capteur de pression ou d'un interrupteur, à augmenter la sensibilité du système de conversion d'énergie.

Un autre mode de réalisation vise, dans le cas d'une utilisation du système de conversion d'énergie pour la réalisation d'un interrupteur, à fournir une réaction mécanique à l'utilisateur lorsque celui-ci actionne l'interrupteur.

Ainsi, un mode de réalisation prévoit un système de conversion d'énergie, comprenant :
un premier dispositif comprenant une enceinte déformable contenant des molécules thermo-réactives adaptées à déformer l'enceinte lorsque la température dépasse une température seuil ; et
un deuxième dispositif pyroélectrique et/ou piézoélectrique au contact de l'enceinte.

Selon un mode de réalisation, le deuxième dispositif comprend un film comprenant du polyfluorure de vinylidène et/ou au moins un copolymère du polyfluorure de vinylidène.

Selon un mode de réalisation, le film comprend un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

Selon un mode de réalisation, les molécules thermo-réactives sont des molécules ayant une température caractéristique de transition et qui sont adaptées, lorsqu'elles sont soumises à une variation de température d'une première température strictement inférieure à la température caractéristique de transition à une deuxième température strictement supérieure à la température caractéristique de transition, de passer d'un premier état dans lequel l'enceinte occupe un premier volume à un deuxième état dans lequel l'enceinte occupe un deuxième volume différent du premier volume, et adaptées, lorsqu'elles sont soumises à une variation de température de la deuxième température à la première température, de passer du deuxième état au premier état.

Selon un mode de réalisation, les molécules thermo-réactives sont choisies parmi le groupe comprenant le poly (N-isopropyl acrylamide), le polyvinylcaprolactame, l'hydroxypropylcellulose, le polyoxazoline, le polyvinylméthyléther, le polyéthylèneglycol, le poly-3-diméthyl(méthacryloyloxyéthyl) ammonium propane sulfonate, le poly(propyl sulfonate diméthyl ammonium éthyl méthacrylate) et le mélange d'au moins deux de ces polymères.

Un autre mode de réalisation prévoit un procédé de fabrication d'un système de conversion d'énergie, comprenant les étapes suivantes :
former un premier dispositif comprenant une enceinte déformable contenant des molécules thermo-réactives adaptées à déformer l'enceinte lorsque la température dépasse une température seuil ; et
former un deuxième dispositif pyroélectrique et/ou piézoélectrique, le deuxième dispositif étant au contact de l'enceinte.

Selon un mode de réalisation, le deuxième dispositif piézoélectrique et/ou pyroélectrique comprend un film comprenant du polyfluorure de vinylidène et/ou au moins un copolymère du polyfluorure de vinylidène, le procédé comprenant les étapes suivantes :
former une portion d'une solution comprenant un solvant et un composé comprenant du polyfluorure de vinylidène et/ou ledit au moins un copolymère du polyfluorure de vinylidène ; et
irradier, au moins partiellement, la portion avec des impulsions d'au moins un rayonnement ultraviolet.

Selon un mode de réalisation, la durée de chaque impulsion est comprise entre 500 µs et 2 ms.

Selon un mode de réalisation, la fluence du rayonnement ultraviolet est comprise entre 10 J/cm² et 25 J/cm².

Selon un mode de réalisation, le solvant a une température d'évaporation comprise entre 110 °C et 140 °C.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une coupe, partielle et schématique, d'un mode de réalisation d'un système de conversion d'énergie mécanique et/ou thermique en énergie électrique ;
la figure 2 est une coupe analogue à la figure 1, dans le cas d'une utilisation du mode de réalisation du système de conversion d'énergie représenté en figure 1 comme interrupteur ; et
les figures 3A à 3H sont des coupes, partielles et schématiques, des structures obtenues à des étapes successives d'un mode de réalisation d'un procédé de fabrication du système de conversion d'énergie des figures 1 et 2.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, le circuit de traitement des signaux électriques fournis par le système de conversion d'énergie est bien connu de l'homme du métier selon l'application envisagée et n'est pas décrit en détail par la suite. Dans la suite de la description, sauf indication contraire, les termes "sensiblement", "environ" et "de l'ordre de" signifient "à 10 % près". Dans la suite de la description, l'expression élément "à base de polyfluorure de vinylidène (PVDF)" signifie un élément comprenant au moins 70 % en poids du polymère PVDF et/ou d'au moins un copolymère du PVDF.

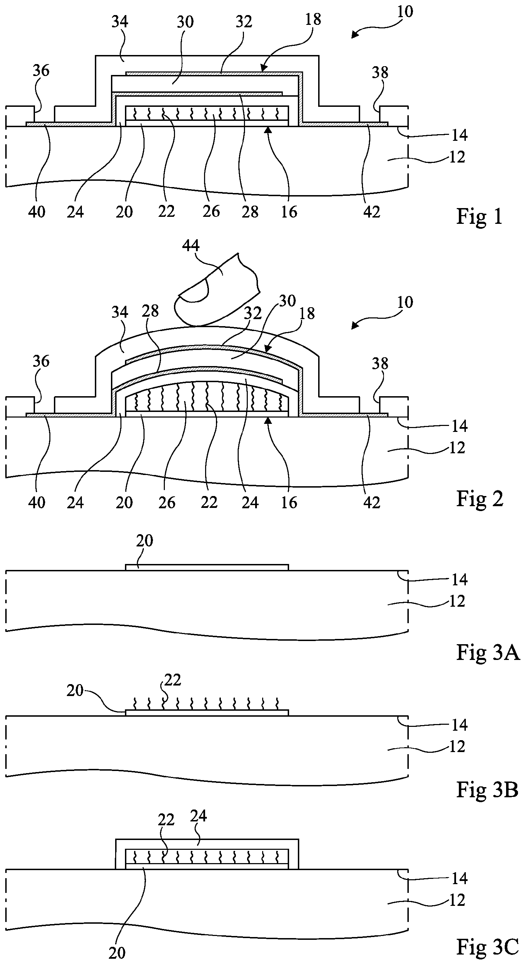

La figure 1 représente un mode de réalisation d'un système de conversion d'énergie 10.

Le système 10 comprend un substrat 12 ayant une face supérieure 14. Le substrat 12 peut être en un matériau isolant ou semiconducteur. A titre d'exemple, le substrat 12 est réalisé en verre, en silicium, ou dans une matière plastique. Le substrat 12 peut être réalisé en un polymère, par exemple un polyimide, du polyéthylène naphtalate (PEN) ou du polyéthylène téréphtalate (PET). A titre d'exemple, l'épaisseur du substrat 12 est comprise entre 25 µm et 200 µm. Le substrat 12 peut être flexible.

Le système 10 comprend un dispositif 16 pouvant être actionné par la température, appelé dispositif thermo-actionnable par la suite, et un dispositif piézoélectrique et/ou pyroélectrique 18. Dans le présent mode de réalisation, le dispositif thermo-actionnable 16 est interposé entre le substrat 12 et le dispositif piézoélectrique et/ou pyroélectrique 18. Toutefois, à titre de variante, le dispositif piézoélectrique et/ou pyroélectrique 18 peut être interposé entre le dispositif thermo-actionnable 16 et le substrat 12.

Le dispositif thermo-actionnable 16 comprend une couche d'accroche 20 reposant sur la face 14 et sur laquelle sont fixées des molécules 22 à changement d'état en fonction de la température, appelées par la suite molécules thermo-réactives. La nature de la couche d'accroche 20 dépend de la nature des molécules thermo-réactives 22. L'épaisseur de la couche d'accroche 20 peut être comprise entre 10 nm et 100 nm, par exemple d'environ 30 nm. A titre de variante, la couche 20 peut être une couche métallique ou une couche non métallique, par exemple réalisée en fullerène ou en polystyrène.

On entend par molécule thermo-réactive une molécule de polymère qui montre un changement important et discontinu d'au moins une propriété physique en fonction de la température. Selon un mode de réalisation, les molécules thermo-réactives 22 ont une température caractéristique de transition et sont dans un premier état, c'est-à-dire avec une propriété physique à un premier niveau, lorsque la température est inférieure à la température caractéristique de transition et sont dans un deuxième état, c'est-à-dire avec une propriété physique à un deuxième niveau, lorsque la température est supérieure à la température caractéristique de transition. Ce changement est, de préférence, réversible de sorte que les molécules passent du premier état au deuxième état lorsque la température s'élève au-dessus de la température caractéristique de transition et passe du deuxième état au premier état lorsque la température diminue au-dessous de la température caractéristique de transition.

Selon un mode de réalisation, la propriété considérée est la conformation tridimensionnelle de la molécule. Selon un autre mode de réalisation, la propriété considérée est la solubilité de la molécule dans un solvant. Selon un autre mode de réalisation, la propriété considérée est l'hydrophobie de la molécule.

Selon un mode de réalisation, dans le premier état, les molécules thermo-réactives 22 peuvent avoir une affinité pour l'eau donnée, tandis que dans le deuxième état, les molécules thermo-réactives 22 peuvent avoir une affinité inverse pour l'eau. Par exemple, dans le premier état, les molécules thermo-réactives 22 peuvent être hydrophobes (inversement hydrophiles) alors que dans le deuxième état, les molécules thermo-réactives 22 peuvent être hydrophiles (inversement hydrophobes). Plus généralement, les molécules thermo-réactives 22 peuvent être telles qu'elles sont susceptibles de passer d'un caractère solvéophobe (inversement solvéophile) à un caractère solvéophile (inversement solvéophobe) à la suite d'une variation de température.

Avantageusement, les molécules thermo-réactives 22 peuvent être choisies parmi un ou plusieurs polymères suivants : poly(N-isopropylacrylamide) (polyNIPAM), polyvinylcaprolactame, hydroxypropylcellulose, polyoxazoline, polyvinylméthyléther, polyéthylèneglycol, poly-3-diméthyl(méthacryloyloxyéthyl) ammonium propane sulfonate (PDMAPS), et poly(propyl sulfonate diméthyl ammonium éthylméthacrylate).

Les températures caractéristiques de transition de ces matériaux sont les suivantes :
polyNIPAM : entre 30 et 37 °C ;
polyvinylcaprolactame : 37 °C ;
hydroxypropylcellulose : entre 40 et 56 °C ;
polyoxazoline : 70 °C ;
polyvinylméthyléther : 45 °C ;
polyéthylèneglycol : entre 100 et 130 °C ;
PDMAPS : entre 32 et 35 °C ;
poly(propyl sulfonate diméthyl ammonium éthyl méthacrylate) : 30°C.

Dans le présent mode de réalisation, pour une application dans laquelle le système 10 est utilisé comme interrupteur mécanique actionné par un utilisateur, la température caractéristique de transition des molécules thermo-réactives 22 est de préférence comprise entre 30 °C et 37 °C.

Pour une application comme interrupteur actionné par le doigt d'un opérateur, la molécule thermo-réactive 22 est de préférence le PDMAPS dont la température caractéristique de transition est comprise entre 32°C et 35°C et qui passe d'un état hydrophobe à un état hydrophile lorsque la température dépasse la température caractéristique de transition.

Le matériau comprenant les molécules PDMAPS peut se présenter sous la forme d'un gel aqueux qui occupe un premier volume lorsque la température est au-dessous de la température caractéristique de transition et un deuxième volume, strictement supérieur au premier volume, lorsque la température est au-dessus de la température caractéristique de transition.

Selon un mode de réalisation, les molécules thermo-réactives 22 peuvent être formées de plusieurs types de polymères thermo-activables, notamment avec des températures caractéristiques de transition respectives distinctes.

Il est possible de modifier la température caractéristique de transition du polymère thermo-réactif en rajoutant un sel ou en ajoutant un tensio-actif ou un solvant approprié au polymère. De la même manière, une modification de la température caractéristique de transition pour une famille de polymère thermo-réactif peut être réalisée par formation d'un copolymère, le copolymère portant au choix une charge ou un groupement amphiphile.

Le dispositif 16 comprend un capot 24 recouvrant les molécules thermo-réactives 22 et qui délimite, avec le substrat 12, une enceinte 26 contenant les molécules thermo-réactives 22. Le capot 24 est adapté pour pouvoir être déformé lors de l'application de contraintes mécaniques extérieures. Dans ce but, à titre d'exemple, l'épaisseur du capot 24 est comprise entre 1 µm et 2 µm, pour obtenir une membrane flexible.

De préférence, le capot 24 est en un matériau qui permet d'avoir un bon apport en humidité dans l'enceinte 26. A titre d'exemple, pour confiner l'eau ou l'humidité dans l'enceinte 26, il peut être prévu sur les parois internes de l'enceinte 16 une ou plusieurs zones présentant une bonne affinité avec l'eau comme par exemple du polyimide (PI) ou du polydiméthylsiloxane (PDMS). A titre d'exemple, le capot 24 est en un matériau choisi parmi le groupe comprenant le polyimide, le poly(méthyl méthacrylate) (PMMA), le poly(vinylcrotonate) et le PET. Le capot 24 peut comprendre des ouvertures pour permettre le passage de l'humidité.

Le dispositif pyroélectrique/piézoélectrique 18 comprend :
une première électrode 28 qui s'étend sur une partie du capot 24 et sur une partie de la face 14 ;
un film pyroélectrique et/ou piézoélectrique 30 recouvrant une partie de l'électrode 28 ; et
une deuxième électrode 32 qui s'étend sur le film 30 et sur une partie de la face 14.

La première électrode 28 est, de préférence, en un matériau réfléchissant le rayonnement ultra-violet, par exemple sur une plage de longueurs d'onde comprises entre 200 nm et 400 nm. Il peut s'agir d'une couche métallique. A titre d'exemple, le matériau composant la première électrode 28 est choisi parmi le groupe comprenant l'argent (Ag), l'aluminium (Al), l'or (Au) ou un mélange ou un alliage de deux ou plus de deux de ces métaux.

Le film 30 comprend un matériau pyroélectrique et/ou piézoélectrique. De préférence, le film pyroélectrique et/ou piézoélectrique 30 est disposé de façon à avoir une activité pyroélectrique et/ou piézoélectrique selon une direction perpendiculaire à la face 14. Selon un mode de réalisation, le film 30 est en un matériau polymère.

Selon un mode de réalisation, le film 30 est à base de PVDF. Il peut comprendre le seul polymère PVDF, un seul copolymère du PVDF, un mélange de deux ou plus de deux copolymères du PVDF ou un mélange du polymère PVDF et d'au moins un copolymère du PVDF. De préférence, le copolymère du PVDF est le poly(fluorure de vinylidène - tri fluoro éthylène) (P(VDF-TrFe)) ou le poly(fluorure de vinylidène - tétrafluoroéthylène), notamment le P(VDFₓ₋TrFe₁₀₀₋ₓ) où x est un nombre réel compris entre 60 et 80. Le film 30 peut, en outre, comprendre des charges. Les charges peuvent correspondre à des particules céramiques, par exemple des particules de titanate de baryum (BaPiO₃) ou des particules de zirconate titanate de plomb (PZT). La concentration en poids des charges dans le film 30 peut varier de 5 % à 25 % en poids. L'épaisseur du film 30 est comprise entre 200 nm et 4 µm. Le polymère PVDF ou le copolymère du PVDF du film 30 est un polymère semi-cristallin comprenant notamment une phase cristalline β qui peut présenter des propriétés pyroélectriques et/ou piézoélectriques.

La deuxième électrode 32 est, par exemple, en un matériau métallique choisi parmi le groupe comprenant l'argent, le cuivre ou un mélange ou un alliage d'au moins deux de ces matériaux.

Une couche de protection 34, par exemple en un matériau isolant, recouvre l'ensemble de la structure. Des ouvertures 36, 38 peuvent être prévues dans la couche de protection 34 pour exposer une partie 40 de la première électrode 28 et une partie 42 de la deuxième électrode 32. La couche de protection 34 est en un matériau diélectrique. Le matériau diélectrique peut être choisi dans le groupe comprenant le poly tétra fluoro éthylène (Teflon), un polymère fluoré du type du polymère commercialisé par la société Bellex sous l'appellation Cytop, un polystyrène, et un polyimide.

La figure 2 illustre un exemple d'utilisation du système 10 comme interrupteur actionné par le doigt 44 d'un opérateur. Pour une telle application, les molécules thermo-réactives 22 sont, de préférence, en PDMAPS dont la température caractéristique de transition est comprise entre 32°C et 35°C. Le PDMAPS qui passe d'un état hydrophobe à un état hydrophile lorsque la température dépasse la température caractéristique de transition. Le matériau constituant la couche d'accroche 20 peut être de l'or.

Les molécules PDMAPS peuvent être disposées dans l'enceinte 26 sous la forme d'un gel aqueux qui occupe un premier volume lorsque la température est au-dessous de la température caractéristique de transition et qui occupe un deuxième volume, strictement supérieur au premier volume, lorsque la température est au-dessus de la température caractéristique de transition.

Lorsqu'un utilisateur appuie le doigt 44 sur la partie de la couche de protection 34 recouvrant le film pyroélectrique/piézoélectrique 30, une pression est exercée sur le film 30 ce qui se traduit par l'apparition d'une tension entre les électrodes 28, 32.

Dans le cas où le film 30 a à la fois des propriétés piézoélectriques et pyroélectriques, ce qui peut être le cas d'un film à base de PVDF, la présence du doigt 44 entraîne une élévation de la température du film 30, ce qui augmente la tension entre les électrodes 28, 32.

En outre, la présence du doigt 44 entraîne une élévation de la température dans l'enceinte 26 au-delà de la température caractéristique de transition des molécules thermo-réactives 22. Ceci entraîne une augmentation du volume occupé par les molécules thermo-réactives 22 et une déformation du capot 24. A titre d'exemple, en figure 2, on a représenté le capot 24 avec une forme bombée vers l'extérieur due à l'augmentation du volume de l'enceinte 26. Toutefois, la forme déformée du capot 24 peut être différente de la forme représentée en figure 2. L'épaisseur mince du capot 24 permet de façon avantageuse d'obtenir une importante déformation du capot 24 lors du changement de volume de l'enceinte 26.

La déformation du capot 24 entraîne une déformation supplémentaire du film 30, en plus de la pression exercée par le doigt 44. De ce fait, la tension entre les électrodes 28, 32 est supérieure à celle qui serait obtenue par la seule application du doigt 44. La sensibilité de l'interrupteur est ainsi améliorée.

En outre, lorsqu'il actionne le système 10 en le touchant du doigt 44, l'augmentation brutale du volume de l'enceinte 26 est perçue par l'utilisateur. On obtient ainsi une fonction de retour mécanique sans utilisation de moyens supplémentaires.

Selon un autre exemple d'utilisation, il n'y a pas d'application de pression sur le film piézoélectrique 30 par un organe extérieur. La déformation du film piézoélectrique 30, et donc l'apparition d'une tension entre les électrodes 28 et 32, est obtenue seulement par le changement de volume de l'enceinte 26 lorsque la température dans l'enceinte 26 dépasse la température caractéristique de transition des molécules thermo-réactives 22. A titre d'exemple, le système 10 représenté en figure 1 peut être utilisé comme interrupteur actionné thermiquement. Dans ce cas, la température caractéristique de transition des molécules thermo-réactives 22 est choisie en fonction du seuil de température au-delà duquel un actionnement de l'interrupteur est souhaité. En effet, quand la température dans l'enceinte 26 dépasse la température seuil, le volume de l'enceinte 26 augmente, ce qui entraîne une déformation du film piézoélectrique 30 et donc l'apparition d'une tension entre les électrodes 28 et 32. Selon un autre exemple d'utilisation, la modification de la température dans l'enceinte 26 peut être obtenue par l'application d'une source de chaleur locale au niveau de l'enceinte 26, par exemple par un laser. On obtient alors un système de conversion d'énergie thermique en énergie électrique.

Le présent système 10 de conversion d'énergie peut être également mis en oeuvre comme système de récupération d'énergie thermique ou électrique.

Les figures 3A à 3H illustrent un mode de réalisation d'un procédé de fabrication du système 10 de conversion d'énergie représenté en figure 1.

La figure 3A représente la structure obtenue après avoir formé la couche d'accroche 20 sur le substrat 12. La couche d'accroche peut être déposée par dépôt physique en phase vapeur (PVD).

La figure 3B représente la structure obtenue après avoir greffé les molécules thermosensibles 22 sur la couche d'accroche 20. Le procédé de greffage peut être mis en oeuvre comme cela est décrit dans la publication de A. Housni et Y. Zhao intitulée "Gold Nanoparticles Functionalized with Block Copolymers Displaying Either LCST ou UCST Thermosensitivity in Aqueous Solution", Langmuir, 2010, 26 (15), pp 12933-12939. D'autres exemples de procédés de greffage sont décrits dans la demande de brevet français FR13/54701 dont le contenu est incorporé en totalité à la présente description.

La figure 3C représente la structure obtenue après avoir formé le capot 24. Le capot 24 peut être réalisé par des techniques d'impression, par exemple par impression par jet d'encre, ou par pulvérisation. Une étape de recuit permettant d'évaporer les solvants dans lequel sont dissous les polymères peut être prévue pour former un film. L'étape de recuit peut être réalisée par une irradiation par une succession d'impulsions de rayonnement ultraviolet (UV), ou flashs UV. Par rayonnement UV, on entend un rayonnement dont les longueurs d'onde sont, au moins en partie, comprises entre 200 nm et 400 nm. Selon un mode de réalisation, la durée d'une impulsion UV est comprise entre 500 µs et 2 ms. La durée entre deux impulsions UV successives peut être comprise entre 1 et 5 secondes. La fluence du rayonnement UV peut être comprise entre 10 J/cm² et 21 J/cm².

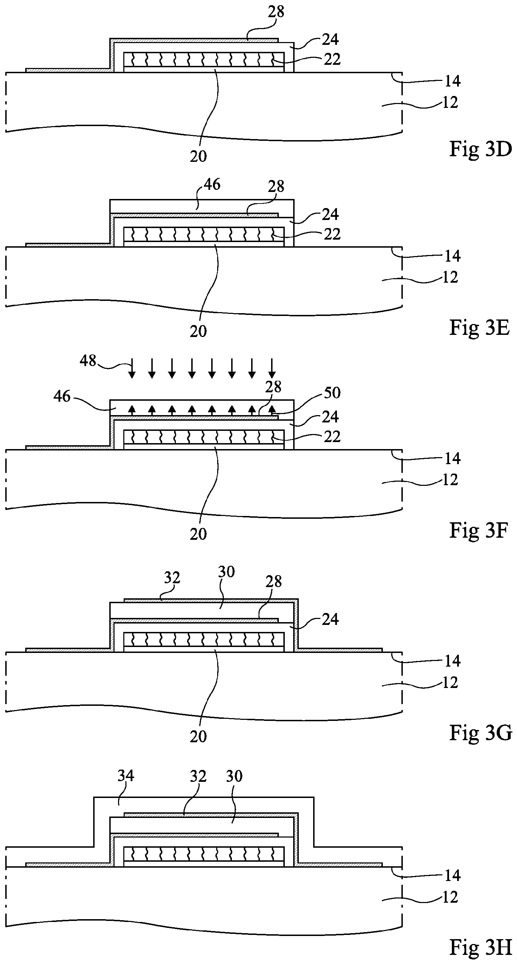

La figure 3D est une coupe, partielle et schématique, de la structure obtenue après avoir formé la première électrode 28 sur le capot 24 et sur le substrat 12. Le dépôt de la première électrode 28 peut être réalisé par PVD ou par des techniques d'impression, notamment par sérigraphie ou par impression à jet d'encre.

La figure 3E représente la structure obtenue après avoir formé une portion liquide 46, éventuellement visqueuse, qui s'étend sur la partie de la première électrode 28 recouvrant le capot 24 et, éventuellement, directement sur une partie du capot 24. La portion liquide 46 comprend un solvant et un composé à base de PVDF dissout dans le solvant. L'épaisseur de la portion 46 est comprise entre 200 nm et 4 µm.

Le composé à base de PVDF peut comprendre le seul polymère PVDF, un seul copolymère du PVDF, un mélange de deux ou plus de deux copolymères du PVDF ou un mélange du polymère PVDF et d'au moins un copolymère du PVDF. De préférence, le copolymère du PVDF est le poly(fluorure de vinylidène - tri fluoro éthylène) (P(VDF-TrFe)) ou le poly(fluorure de vinylidène - tétrafluoroéthylène), notamment le P(VDFₓ-TrFe₁₀₀₋ₓ) où x est un nombre réel compris entre 60 et 80.

Le composé à base de PVDF peut, en outre, comprendre des charges. Les charges peuvent correspondre à des particules en céramique, par exemple des particules de titanate de baryum (BaPiO₃) ou des particules de zirconate titanate de plomb (PZT). La concentration en poids de charges dans le composé à base de PVDF peut varier de 5 % à 25 % en poids.

De préférence, le solvant est un solvant polaire. Ceci permet, de façon avantageuse, d'améliorer la dissolution du polymère à base de PVDF. De préférence, le solvant est adapté à absorber, au moins partiellement, le rayonnement UV, par exemple sur une plage de longueurs d'onde comprises entre 200 nm et 400 nm. Selon un mode de réalisation, la température d'évaporation du solvant est comprise entre 110 °C et 140 °C, de préférence entre 110 °C et 130 °C, plus préférentiellement entre 120 °C et 130 °C. Le solvant peut être choisi parmi le groupe comprenant le cyclopentanone, le diméthylsulphoxide (DMSO), le diméthylformamide (DMF), le diméthylacétamide (DMAc) ou le N-méthyl-E-pyrrolidone (NMP). De préférence, le solvant est le cyclopentanone.

La portion liquide 46 comprend de 1 % à 30 %, de préférence de 1 % à 20 %, en poids du composé à base de PVDF et de 70 % à 99 %, de préférence de 80 % à 99 %, en poids du solvant. De façon avantageuse, la concentration en poids du solvant est choisie pour ajuster la viscosité de la solution obtenue afin de permettre la mise en oeuvre de techniques d'impression. Le procédé de dépôt de la portion 46 peut correspondre à un procédé dit additif, par exemple par impression directe de la portion 46 aux emplacements souhaités, par exemple par impression par jet d'encre, héliographie, sérigraphie, flexographie, revêtement par pulvérisation (en anglais spray coating) ou dépôt de gouttes (en anglais drop-casting). Le procédé de dépôt de la portion 46 peut correspondre à un procédé dit soustractif, dans lequel la portion 46 est déposée sur la totalité de la structure et dans lequel les portions non-utilisées sont ensuite retirées, par exemple par photolithographie ou ablation laser. Selon le matériau considéré, le dépôt sur la totalité de la structure peut être réalisé par exemple par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie.

La figure 3F illustre une étape d'irradiation d'au moins une portion de la portion liquide 46 qui entraîne la formation, dans la portion, d'un film à base de PVDF ayant les propriétés pyroélectriques et/ou piézoélectriques souhaitées. L'irradiation aux rayons UV est représentée de façon schématique en figure 3F par les flèches 48. L'irradiation est réalisée par une succession d'impulsions de rayonnement UV. Selon un mode de réalisation, la durée d'une impulsion UV est comprise entre 500 µs et 2 ms. La durée entre deux impulsions UV successives peut être comprise entre 1 et 5 secondes. La fluence du rayonnement (UV) peut être comprise entre 10 J/cm² et 25 J/cm². Le nombre d'impulsions UV dépend notamment de l'épaisseur de la portion 46. A titre d'exemple, pour une épaisseur de la portion 46 de 200 nm, le nombre d'impulsions UV peut être de l'ordre de 1 à 2 avec une fluence entre 10 J/cm² et 15 J/cm² et pour une épaisseur de la portion 46 de l'ordre de 4 µm, le nombre d'impulsions UV peut être de l'ordre de 2 à 6 avec une fluence entre 17 J/cm² et 21 J/cm².

De façon avantageuse, pendant l'irradiation de la portion 46, la première électrode 28 réfléchit une partie du rayonnement UV ayant traversé la portion 46. Ceci permet d'améliorer la quantité de rayonnement UV reçue par la portion 46. La réflexion des rayons UV est représentée de façon schématique en figure 3F par les flèches 50.

De façon avantageuse, le solvant de la portion 46 absorbe au moins en partie le rayonnement UV. Ceci permet d'améliorer le chauffage du composé à base d'UV et favorise la formation de la phase cristalline β. La température d'évaporation du solvant est avantageusement supérieure à 110 °C pour éviter une évaporation trop rapide du solvant avant la formation de la phase cristalline β qui se produit entre 120 °C et 130 °C.

De préférence, l'étape d'irradiation entraîne une évaporation de plus de 50 %, de préférence de plus de 80 %, en poids du solvant de la portion 46. L'étape d'irradiation entraîne la formation du film 30 pyroélectrique et/ou piézoélectrique.

Les inventeurs ont mis en évidence que le diagramme de diffraction du film 30 comprend deux pics représentatifs de deux phases cristallines β orientées différemment. Les inventeurs ont, en outre, mis en évidence que le film 30 à base de PVDF a une activité pyroélectrique/piézoélectrique améliorée par rapport à un film à base de PVDF qui serait chauffé par une plaque chauffante pendant une durée variant de plusieurs minutes à plusieurs heures.

La figure 3G représente la structure obtenue après avoir déposé la deuxième électrode 32 sur le film 30 et sur une partie du substrat 14, la deuxième électrode 32 ne venant pas au contact de la première électrode 28. L'électrode 32 est, par exemple, en un matériau métallique choisi parmi le groupe comprenant l'argent, le cuivre ou un mélange ou un alliage d'au moins deux de ces matériaux. Selon le matériau considéré, l'électrode 32 peut être déposée par PVD ou par des techniques d'impression, par exemple par impression par jet d'encre ou par sérigraphie. Dans ce cas, une étape de recuit peut alors être prévue, par exemple par irradiation de l'encre déposée par impulsions UV ayant une fluence comprise entre 15 J/cm² et 25 J/cm².

Une étape ultérieure d'application d'un champ électrique à la structure peut être prévue. A titre d'exemple, le champ électrique peut varier entre 20 et 80 V/µm et peut être appliqué à une température comprise entre 70 et 90 °C pendant 5 à 10 minutes.

La figure 3H représente la structure obtenue après la formation de la couche de protection 34. Selon le matériau considéré, la couche de protection 34 peut être déposée par un dépôt chimique en phase vapeur (CVD) ou par des techniques d'impression, par exemple par impression par jet d'encre ou par sérigraphie. Dans ce cas, une étape de recuit peut alors être prévue, par exemple par irradiation de l'encre déposée par impulsions UV ayant une fluence comprise entre 10 J/cm² et 21 J/cm².

Le fait de réaliser les étapes de chauffage des matériaux composant le capot 24 et le dispositif pyroélectrique et/ou piézoélectrique 18 par irradiation UV permet de façon avantageuse d'effectuer un chauffage localisé sans détériorer les molécules thermo-réactives.

Des modes de réalisation particuliers ont été décrits. Diverses variantes et modifications apparaîtront à l'homme de l'art.

## Revendications

1. Système (10) de conversion d'énergie, comprenant :
un premier dispositif (16) comprenant une enceinte (26) déformable contenant des molécules thermo-réactives (22) adaptées à déformer l'enceinte lorsque la température dépasse une température seuil ; et
un deuxième dispositif (18) pyroélectrique et/ou piézoélectrique au contact de l'enceinte.

2. Système selon la revendication 1, dans lequel le deuxième dispositif (18) comprend un film (30) comprenant du polyfluorure de vinylidène et/ou au moins un copolymère du polyfluorure de vinylidène.

3. Système selon la revendication 2, dans lequel le film (30) comprend un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

4. Système selon l'une quelconque des revendications 1 à 3, dans lequel les molécules thermo-réactives (22) sont des molécules ayant une température caractéristique de transition et qui sont adaptées, lorsqu'elles sont soumises à une variation de température d'une première température strictement inférieure à la température caractéristique de transition à une deuxième température strictement supérieure à la température caractéristique de transition, de passer d'un premier état dans lequel l'enceinte (26) occupe un premier volume à un deuxième état dans lequel l'enceinte occupe un deuxième volume différent du premier volume, et adaptées, lorsqu'elles sont soumises à une variation de température de la deuxième température à la première température, de passer du deuxième état au premier état.

5. Système selon la revendication 4, dans lequel les molécules thermo-réactives (22) sont choisies parmi le groupe comprenant le poly (N- isopropyl acrylamide), le polyvinylcaprolactame, l'hydroxypropylcellulose, le polyoxazoline, le polyvinylméthyléther, le polyéthylèneglycol, le poly-3-diméthyl(méthacryloyloxyéthyl) ammonium propane sulfonate, le poly(propyl sulfonate diméthyl ammonium éthyl méthacrylate) et le mélange d'au moins deux de ces polymères.

6. Procédé de fabrication d'un système (10) de conversion d'énergie, comprenant les étapes suivantes :
former un premier dispositif (16) comprenant une enceinte (26) déformable contenant des molécules thermo-réactives adaptées à déformer l'enceinte lorsque la température dépasse une température seuil ; et
former un deuxième dispositif (18) pyroélectrique et/ou piézoélectrique,
dans lequel le deuxième dispositif (18) est au contact de l'enceinte.

7. Procédé selon la revendication 6, dans lequel le deuxième dispositif (18) piézoélectrique et/ou pyroélectrique comprend un film (30) comprenant du polyfluorure de vinylidène et/ou au moins un copolymère du polyfluorure de vinylidène, le procédé comprenant les étapes suivantes :
former une portion (46) d'une solution comprenant un solvant et un composé comprenant du polyfluorure de vinylidène et/ou ledit au moins un copolymère du polyfluorure de vinylidène ; et
irradier, au moins partiellement, la portion avec des impulsions d'au moins un rayonnement ultraviolet.

8. Procédé selon la revendication 7, dans lequel la durée de chaque impulsion est comprise entre 500 µs et 2 ms.

9. Procédé selon la revendication 7 ou 8, dans lequel la fluence du rayonnement ultraviolet est comprise entre 10 J/cm² et 25 J/cm².

10. Procédé selon l'une quelconque des revendications 7 à 9, dans lequel le solvant a une température d'évaporation comprise entre 110 °C et 140 °C.

## Patentansprüche

1. System (10) zum Umwandeln von Energie, welches Folgendes aufweist:
eine erste Vorrichtung (16), die ein verformbares Gehäuse (26) aufweist, das hitzeempfindliche Moleküle (22) enthält, die in der Lage sind, das Gehäuse zu verformen, wenn die Temperatur eine Schwellentemperatur überschreitet; und
eine zweite pyroelektrische und / oder piezoelektrische Vorrichtung (18) in Kontakt mit dem Gehäuse.

2. System nach Anspruch 1, wobei die zweite Einrichtung (18) eine Folie (30) aufweist, die Polyvinylidenfluorid und / oder mindestens ein Copolymer von Polyvinylidenfluorid aufweist.

3. System nach Anspruch 2, wobei die Folie (30) ein Polymer aus der Gruppe aufweist, die aus Folgendem besteht: Polyvinylidenfluorid, Poly(vinylidenfluorid - Trifluorethylen), Poly (vinylidenfluorid-Tetrafluorethylen) und eine Mischung aus mindestens zwei dieser Polymere.

4. System nach einem der Ansprüche 1 bis 3, wobei die hitzeempfindlichen Moleküle (22) Moleküle mit einer charakteristischen Übergangstemperatur sind, und die geeignet sind, wenn sie einer Temperaturänderung unterzogen werden, und zwar von einer ersten Temperatur, die niedriger als die charakteristische Übergangstemperatur ist, auf eine zweite Temperatur, die höher als die charakteristische Übergangstemperatur ist, von einem ersten Zustand, bei dem das Gehäuse (26) ein erstes Volumen einnimmt, zu einem zweiten Zustand überzugehen, bei dem das Gehäuse ein zweites Volumen einnimmt, welches sich von dem ersten Volumen unterscheidet, und die in der Lage sind, wenn sie einer Temperaturänderung von der zweiten Temperatur zur ersten Temperatur unterworfen werden, von dem zweiten Zustand in den ersten Zustand überzugehen.

5. System nach Anspruch 4, wobei die hitzeempfindlichen Moleküle (22) aus der Gruppe ausgewählt sind, die aus Folgendem besteht: Poly(N-isopropylacrylamid), Polyvinylcaprolactam, Hydroxypropylzellulose, Polyoxazolin, Polyvinylmethylether, Polyethylenglykol, Poly-3-dimethyl(methacryloyloxyethyl)ammoniumpropansulfonat, Poly(propylsulfonatdimethylammoniumethylmethacrylat) und die Mischung aus mindestens zwei dieser Polymere.

6. Verfahren zur Herstellung eines Systems (10) zur Energieumwandlung, welches die folgenden Schritte aufweist:
Bilden einer ersten Vorrichtung (16), die ein verformbares Gehäuse (26) aufweist, das hitzeempfindliche Moleküle enthält, die in der Lage sind, das Gehäuse zu verformen, wenn die Temperatur eine Schwellentemperatur überschreitet; und
Bilden einer zweiten pyroelektrischen und/oder piezoelektrischen Vorrichtung (18),
wobei die zweite Einrichtung (18) in Kontakt mit dem Gehäuse ist.

7. Verfahren nach Anspruch 6, wobei die zweite pyroelektrische und / oder piezoelektrische Einrichtung (18) eine Folie (30) aufweist, die Polyvinylidenfluorid und/oder mindestens ein Copolymer von Polyvinylidenfluorid aufweist, wobei das Verfahren folgende Schritte aufweist:
Bilden eines Teils (46) einer Lösung, die ein Lösungsmittel und eine Verbindung aufweist, die Polyvinylidenfluorid und / oder das mindestens eine Copolymer von Polyvinylidenfluorid aufweist; und
Bestrahlen, zumindest teilweise, dieses Teils mit Impulsen von zumindest einer Ultraviolettstrahlung.

8. Verfahren nach Anspruch 7, wobei die Dauer jedes Impulses zwischen 500 µs und 2 ms beträgt.

9. Verfahren nach Anspruch 7 oder 8, wobei die Fluenz der Ultraviolettstrahlung im Bereich von 10 J/cm² und 25 J/cm² liegt.

10. Verfahren nach einem der Ansprüche 7 bis 9, wobei das Lösungsmittel eine Verdampfungstemperatur im Bereich von 110 °C bis 140 °C hat.

## Claims

1. An energy conversion system (10) comprising:
a first device (16) comprising a deformable enclosure (26) containing heat-sensitive molecules (22) capable of deforming the enclosure when the temperature exceeds a threshold temperature; and
a second pyroelectric and/or piezoelectric device (18) in contact with the enclosure.

2. The system of claim 1, wherein the second device (18) comprises a film (30) comprising polyvinylidene fluoride and/or at least one copolymer of polyvinylidene fluoride.

3. The system of claim 2, wherein the film (30) comprises a polymer selected from the group comprising polyvinylidene fluoride, poly(vinylidene fluoride - trifluoroethylene), poly(vinylidene fluoride - tetrafluoroethylene), and a mixture of at least two of these polymers.

4. The system of any of claims 1 to 3, wherein the heat-sensitive molecules (22) are molecules having a characteristic transition temperature and which are adapted, when they are submitted to a temperature variation from a first temperature lower than the characteristic transition temperature to a second temperature higher than the characteristic transition temperature, of passing from a first state where the enclosure (26) occupies a first volume to a second state where the enclosure occupies a second volume different from the first volume, and capable, when they are submitted to a temperature variation from the second temperature to the first temperature, of passing from the second state to the first state.

5. The system of claim 4, wherein the heat-sensitive molecules (22) are selected from the group comprising poly *(N-*isopropyl acrylamide), polyvinylcaprolactame, hydroxypropylcellulose, polyoxazoline, polyvinylmethylether, polyethylene glycol, poly-3-dimethyl(methacryloyloxyethyl) ammonium propane sulfonate, poly(propyl sulfonate dimethyl ammonium ethyl methacrylate), and the mixture of at least two of these polymers.

6. A method of manufacturing an energy conversion system (10), comprising the steps of:
forming a first device (16) comprising a deformable enclosure (26) containing heat-sensitive molecules capable of deforming the enclosure when the temperature exceeds a threshold temperature; and
forming a second pyroelectric and/or piezoelectric device (18),
wherein the second device (18) is in contact with the enclosure.

7. The method of claim 6, wherein the second pyroelectric and/or piezoelectric device (18) comprises a film (30) comprising polyvinylidene fluoride and/or at least one copolymer of polyvinylidene fluoride, the method comprising the steps of:
forming a portion (46) of a solution comprising a solvent and a compound comprising polyvinylidene fluoride and/or said at least one copolymer of polyvinylidene fluoride; and
irradiating, at least partially, the portion with pulses of at least one ultraviolet radiation.

8. The method of claim 7, wherein the duration of each pulse is in the range from 500 µs to 2 ms.

9. The method of claim 7 or 8, wherein the fluence of the ultraviolet radiation is in the range from 10 J/cm² to 25 J/cm².

10. The method of any of claims 7 to 9, wherein the solvent has an evaporation temperature in the range from 110°C to 140°C.
